# FASCICULE DE BREVET EUROPEEN

(11) **EP 4 030 467 B1**
(45) Date de publication et mention de la délivrance du brevet: **19.07.2023**
(21) Numéro de dépôt: 22151346.8
(22) Date de dépôt: 13.01.2022
(51) Int. Cl.: H01L 21/762, H01L 21/18, H01L 21/02, H01L 21/265, H01L 21/268

(54) **PROCÉDÉ DE COLLAGE DIRECT HYDROPHILE DE SUBSTRATS**
VERFAHREN ZUM DIREKTEN HYDROPHILEN BONDEN VON SUBSTRATEN
METHOD FOR DIRECT HYDROPHILIC BONDING OF SUBSTRATES

(30) Priorité: 14.01.2021 FR 2100362
(43) Date de publication de la demande: 20.07.2022
(73) Titulaire: Commissariat à l'Energie Atomique et aux Energies Alternatives, 75015 Paris (FR)
(72) Inventeur: REBOH, Shay, 38054 GRENOBLE Cedex 09 (FR); LARREY, Vincent, 38054 GRENOBLE Cedex 09 (FR); FOURNEL, Frank, 38054 GRENOBLE Cedex 09 (FR)
(74) Mandataire: Hautier IP

(56) Documents cités:
- US-A1- 2003 129 780
- US-A1- 2003 141 502
- US-A1- 2006 264 004

## Description

### DOMAINE TECHNIQUE

L'invention concerne un procédé de collage direct hydrophile de substrats pour applications en microélectronique, optoélectronique ou optique. Elle trouve pour application particulièrement avantageuse l'intégration monolithique en 3D de composants microélectroniques.

### ETAT DE LA TECHNIQUE

Il est connu de coller des substrats, notamment des substrats semi-conducteurs, afin de former des structures adaptées à la fabrication de dispositifs pour la microélectronique, l'optoélectronique ou l'optique.

Par exemple, les structures de type semi-conducteur sur isolant comprennent successivement un substrat support, une couche électriquement isolante et une couche mince semi-conductrice, dite couche active. Lorsque la couche active est en silicium, la structure est dite « silicium sur isolant » (ou SOI, acronyme du terme anglo-saxon « Silicon On Insulator »). La couche électriquement isolante est généralement une couche d'oxyde de silicium et est souvent dite « couche d'oxyde enterrée » (ou BOX, acronyme du terme anglo-saxon Buried OXide »).

Un procédé particulièrement avantageux pour former de telles structures est le procédé Smart Cut ^{™}. Ce procédé comprend typiquement les étapes suivantes :
- la fourniture d'un substrat support ;
- la fourniture d'un substrat donneur de silicium, recouvert d'une couche d'oxyde de silicium, par exemple formée par oxydation thermique ;
- l'implantation d'espèces ioniques, telles que de l'hydrogène et/ou de l'hélium, dans le substrat donneur au travers de la couche d'oxyde de silicium, de sorte à former une zone de fragilisation délimitant la couche mince à transférer ;
- le collage du substrat donneur sur le substrat support, la couche d'oxyde de silicium se trouvant à l'interface de collage ;
- la fracture du substrat donneur le long de la zone de fragilisation et le détachement du reliquat du substrat donneur de sorte à transférer la couche mince de silicium sur le substrat donneur.

De préférence, le collage est un collage direct, c'est-à-dire sans couche adhésive mise en oeuvre. On parle également de collage moléculaire pour désigner un tel collage. Ce collage est avantageusement de type hydrophile, c'est-à-dire que l'adhésion entre le substrat donneur et le substrat support se fait par l'intermédiaire de molécules d'eau présentes à l'interface de collage. L'eau est éliminée ultérieurement par la mise en oeuvre d'un traitement thermique. Avantageusement, ce collage est réalisé à pression ambiante.

Pour assurer un collage de bonne qualité, les surfaces en contact du substrat support et du substrat donneur doivent présenter une très faible rugosité, typiquement de l'ordre de 1 à quelques nm RMS. Malgré cela, du fait de la rigidité et la dureté importantes des substrats, leur mise en contact va toujours s'effectuer sur quelques aspérités.

Les aspérités présentes à la surface des substrats engendrent des cavités à l'interface entre les deux substrats ; l'interface de collage n'est donc pas totalement fermée. Cependant, lorsque l'on applique un traitement thermique à haute température, la surface de contact croît, du fait de la mobilité atomique à l'interface, jusqu'à écraser les aspérités, ce qui conduit à supprimer les cavités ; l'interface de collage est alors fermée.

Une telle fermeture de l'interface de collage ne peut toutefois être obtenue qu'au prix d'un budget thermique important. Ainsi, pour un collage entre deux couches d'oxyde thermique, la température à appliquer est typiquement de 1200°C pendant plusieurs heures. Pour un collage entre une couche d'oxyde thermique et un substrat de silicium (éventuellement recouvert d'un oxyde natif), la température à appliquer est typiquement de 1100°C pendant 2 heures ; cette température peut être réduite à 1050°C pendant 2 heures lorsque l'on applique au préalable un traitement plasma à la couche d'oxyde.

De tels traitements thermiques à haute température sont généralement très coûteux. Ils doivent être réalisés avec des montées en température lentes afin de ne pas risquer de déformer les substrats, ce qui occasionne des temps de traitement longs, ou bien dans des conditions de chauffe extrêmement contrôlées, ce qui nécessite des équipements complexes. Par ailleurs, les matériaux semi-conducteurs peuvent s'endommager à haute température.

Il serait donc souhaitable de minimiser la température du traitement thermique de fermeture de l'interface, tout en garantissant la fermeture de cette interface.

En effet, un défaut de fermeture de l'interface peut être extrêmement dommageable à l'intégrité et aux performances de la structure collée.

Une première conséquence d'une fermeture imparfaite de l'interface est un décollement localisé, notamment sur les bords de la structure collée. Les zones décollées sur le bord des plaques viennent se redéposer localement sur la surface du substrat, créant des zones impropres à la fabrication ultérieure de dispositifs électroniques. Ces défauts sont dénommées « flakes » selon la terminologie anglo-saxonne.

Une deuxième conséquence d'une fermeture imparfaite de l'interface est que les cavités présentes au niveau de l'interface sont des zones susceptibles d'être attaquées de manière privilégiée par un agent de gravure chimique. L'agent de gravure peut en effet s'insérer dans l'interface par ces cavités et graver préférentiellement les matériaux présents à l'interface.

L'ajout de couches métalliques (par exemple cuivre, tungstène) à l'interface de collage ou bien de dépôts de polymères permet d'atteindre des températures de fermeture de l'interface basses, typiquement inférieures à 500°C. Cependant, les matériaux métalliques, étant électriquement conducteurs ou générateurs d'impuretés dans les substrats semi-conducteurs, sont incompatibles avec un grand nombre d'applications microélectroniques. Par ailleurs, les polymères sont instables aux températures de fabrication des circuits.

Il existe par ailleurs des structures adaptées à la formation de dispositifs par intégration monolithique en 3D de composants microélectroniques.

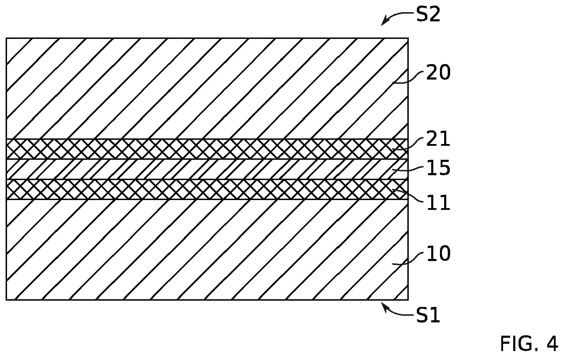

Une telle structure est par exemple représentée sur la figure 4. Cette figure représente plus particulièrement une structure à deux niveaux d'intégration de composants microélectroniques, tels que des transistors, à partir de laquelle un dispositif microélectronique tridimensionnel peut être formé. La structure illustrée comprend :
- un substrat inférieur S1 (ou « bottom substrate » en anglais) constituant un premier des deux niveaux d'intégration,
- un substrat supérieur S2 (ou « top substrate » en anglais) constituant le second des deux niveaux d'intégration,
- une couche électriquement conductrice 15, par exemple à base de silicium polycristallin ou d'un métal, située entre les substrats inférieur S1 et supérieur S2, et
- deux couches 11 et 21 en un matériau diélectrique isolant chacune électriquement le plan de masse 15 et l'un des substrats inférieur et supérieur.

Une telle structure peut être obtenue par un procédé comprenant les étapes suivantes :
- Fournir un substrat inférieur S1 comprenant sur une de ses faces principales une couche en un matériau diélectrique 11,
- Fournir un substrat supérieur S2 comprenant sur une de ses faces principales une couche en un matériau diélectrique 21,
- Déposer une couche de silicium amorphe contenant des éléments dopants sur la couche en un matériau diélectrique 11, 21 de l'un des substrats inférieur et supérieur,
- Déposer une couche en un matériau diélectrique sur la couche de silicium amorphe contenant des éléments dopants,
- Cristalliser la couche de silicium amorphe contenant des éléments dopants pour la transformer en une couche de silicium polycristallin dopé destinée à constituer la couche électriquement conductrice 15 de la structure,
- Traiter les surfaces exposées des couches en un matériau diélectrique par polissage mécano-chimique (ou CMP pour « chemical mechanical polishing » selon la terminologie anglo-saxonne), puis
- Mettre en contact lesdites surfaces exposées l'une avec l'autre pour obtenir le collage direct de ces surfaces entre elles.

La formation d'une telle structure implique donc un collage entre deux couches diélectriques, en général d'oxyde et par voie souffre des mêmes inconvénients que ceux mentionnés ci-dessus relatifs aux structures de type semi-conducteur sur isolant. Notamment, l'ajout de couches métalliques (par exemple cuivre, tungstène) à l'interface de collage resterait générateur d'impuretés dans les substrats semi-conducteurs. En outre, l'ajout de dépôts de polymères à l'interface de collage serait incompatible avec les températures de fabrication des dispositifs microélectroniques tridimensionnels.

Par exemple, les documents US2003129780A1, US2006264004A1 et US2003141502 A1 décrivent une méthode de formation d'une structure SOI comprenant une couche amorphe dopée à l'interface de collage.

Un objet de la présente invention est donc de proposer un procédé de collage direct hydrophile de deux substrats dans lequel l'interface de collage est fermée au moyen d'un traitement thermique à température plus basse que dans les procédés existants.

Un autre objet de la présente invention est de proposer un procédé de fabrication d'une structure telle que représentée sur la figure 4 dans lequel l'interface de collage est fermée au moyen d'un traitement thermique à température plus basse que dans les procédés existants et/ou dans lequel le polissage mécano-chimique des surfaces à coller entre elles n'est pas nécessaire.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre au moins l'un des objectifs susmentionnés, selon un mode de réalisation, on prévoit un procédé de collage direct hydrophile d'un premier substrat sur un deuxième substrat, comprenant :
- La fourniture d'un premier substrat présentant une première surface principale et d'un deuxième substrat présentant une deuxième surface principale,
- la mise en contact du premier substrat et du deuxième substrat du côté respectivement de leurs première et deuxième surfaces principales, de sorte à former une interface de collage entre deux surfaces de collage,
- l'application d'un traitement thermique adapté pour fermer ladite interface de collage,
ledit procédé étant caractérisé en ce qu'il comprend, avant l'étape de mise en contact, la formation, sur la première surface principale et/ou sur la deuxième surface principale, d'une couche de collage en un matériau semi-conducteur amorphe comportant des éléments dopants et d'épaisseur inférieure ou égale à 50 nm, et avantageusement comprise entre 3 et 20 nm, voire entre 3 et 10 nm, une face de ladite couche de collage constituant une des deux surfaces de collage, une couche d'oxyde étant disposée à moins de 20 nm, et avantageusement à moins de 10 nm, voire à moins de 6 nm, de l'interface de collage.

Ainsi, le procédé selon l'invention permet de fabriquer, à basse température, et plus particulièrement à une température inférieure ou égale à 900°C, voire inférieure ou égale à 600°C, une structure composite comportant une couche électriquement conductrice enterrée, comme dans le cas de la structure représentée sur la figure 4 et discutée en introduction. Plus particulièrement, le fait que la couche de collage soit dopée et soit présente à l'interface de collage active la plasticité de la surface de collage qu'elle constitue et permet une fermeture d'interface à température plus faible que sans dopage ; la présence de la couche d'oxyde à moins de 20 nm de l'interface de collage va permettre de gérer l'eau présente à l'interface de collage permettant la fermeture de l'interface de collage.

Lorsque la couche d'oxyde est située sous la couche de collage, cette dernière est de préférence d'une épaisseur inférieure à 20 nm. En alternative, la couche de collage peut être située uniquement sur l'une parmi la première surface principale et la deuxième surface principale et la couche d'oxyde peut être située sur l'autre parmi la première surface principale et la deuxième surface principale. Dans cette alternative, l'épaisseur de la couche de collage n'est pas préférentiellement limitée à 20 nm, mais peut par exemple être d'épaisseur comprise entre 20 et 50 nm.

Un autre aspect concerne un dispositif obtenu par le procédé introduit ci-dessus.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1A représente schématiquement une vue en coupe des premier et deuxième substrats avant leur mise en contact selon un premier mode de réalisation de l'invention.
La figure 1B représente schématiquement une vue en coupe des premier et deuxième substrats après l'application du traitement thermique de fermeture de l'interface de collage selon le premier mode de réalisation de l'invention.
La figure 1C représente schématiquement une vue en coupe de l'assemblage de la figure 1B, le premier substrat ayant été aminci et les couches de collage ayant été cristallisées.
La figure 2A représente schématiquement une vue en coupe des premier et deuxième substrats avant leur mise en contact selon un deuxième mode de réalisation de l'invention.
La figure 2B représente schématiquement une vue en coupe des premier et deuxième substrats après l'application du traitement thermique de fermeture de l'interface de collage selon le deuxième mode de réalisation de l'invention.
La figure 2C représente schématiquement une vue en coupe de l'assemblage de la figure 2B, le premier substrat ayant été aminci et les couches de collage ayant été cristallisées.
Les figures 3A à 3D représentent schématiquement des vues en coupe illustrant successivement une variante du procédé selon son deuxième mode de réalisation.
La figure 4 représente schématiquement une vue en coupe d'un exemple de structure à partir de laquelle un dispositif microélectronique tridimensionnel peut être formé.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs et les largeurs des différents éléments illustrés ne sont pas nécessairement représentatifs de la réalité ou de facteurs de forme réalistes.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la couche de collage présente une épaisseur sensiblement comprise entre 1 et 50 nm, plus particulièrement entre 3 et 10 nm.

Selon un exemple, le traitement thermique est mis en oeuvre à une température sensiblement inférieure ou égale à 900°C, de préférence sensiblement inférieure ou égale à 600°C.

Selon un exemple, la formation de la couche de collage en un matériau semi-conducteur amorphe comportant des éléments dopants comprend une étape de dépôt dudit matériau semi-conducteur amorphe sur ladite surface principale du substrat correspondant, les éléments dopants étant introduits dans la couche de collage lors du dépôt du matériau semi-conducteur amorphe ou après ce dépôt par implantation.

Selon un exemple alternatif à l'exemple précédent, la formation de la couche de collage en un matériau semi-conducteur amorphe comportant des éléments dopants comprend :
- une étape de formation d'une couche dite polycristalline à base d'un matériau semi-conducteur polycristallin sur ladite surface principale du substrat correspondant, puis
- une étape d'amorphisation d'au moins une partie de l'épaisseur de la couche polycristalline, depuis une surface exposée de celle-ci, de sorte à former ladite couche de collage, cette dernière présentant de préférence une épaisseur sensiblement comprise entre 1 et 20 nm, et préférentiellement comprise entre 2 et 5 nm,
la couche polycristalline comprenant les éléments dopants ou ceux-ci étant introduits par implantation dans la couche de collage après l'étape d'amorphisation.

Selon un exemple alternatif aux deux exemples précédents, la formation de la couche de collage en un matériau semi-conducteur amorphe comportant des éléments dopants comprend :
- une étape de formation d'une couche dite polycristalline à base d'un matériau semi-conducteur polycristallin dopé sur ladite surface principale du substrat correspondant, puis
- une étape de dépôt du matériau semi-conducteur amorphe sur la couche polycristalline, les éléments dopants étant introduits dans la couche de collage lors du dépôt du matériau semi-conducteur amorphe ou après ce dépôt par implantation.

Selon un exemple, le premier substrat et le deuxième substrat comprennent chacun une couche en un matériau semi-conducteur monocristallin, l'un au moins des premier et deuxième substrats comportant une couche en un matériau diélectrique disposée sur la couche en un matériau semi-conducteur monocristallin, la première et/ou la deuxième surface principale étant formée par la face libre de la couche en un matériau diélectrique. La couche d'oxyde peut être constituée par, ou être comprise dans, la couche en un matériau diélectrique.

Selon un exemple, la teneur de la couche de collage en éléments dopants est paramétrée, au moins en termes de nature et de concentration des éléments dopants, de sorte que l'étape de cristallisation génère une couche polycristalline électriquement conductrice. Le(s) élément(s) dopant(s) sont de préférence choisis parmi le phosphore, le bore, l'arsenic, le gallium... L'introduction des éléments dopants de la couche de collage peut être réalisée par implantation ionique du(des) éléments(s) dopant(s) dans une couche à base d'un matériau semi-conducteur préalablement formée sur ladite surface principale du substrat correspondant ; en alternative, le dopage de la couche de collage peut être réalisé par dépôt d'une couche en un matériau semi-conducteur sur ladite surface principale du substrat correspondant en présence d'un gaz ou plasma comprenant le(s) élément(s) dopant(s).

Selon un exemple, le premier substrat et le deuxième substrat comprennent chacun une couche en un matériau semi-conducteur et une couche en un matériau diélectrique et la mise en contact des premier et deuxième substrats est telle que la couche en un matériau diélectrique de chaque substrat isole électriquement la couche en un matériau semi-conducteur du substrat et l'interface de collage fermée par l'application du traitement thermique. Il est ainsi possible de fabriquer une structure telle que celle illustrée sur la figure 4. La couche en un matériau diélectrique de l'un au moins des premier et deuxième substrats, voire de chaque substrat, peut être formée par oxydation thermique d'une épaisseur du substrat. L'une au moins des couches en un matériau diélectrique du premier substrat et du deuxième substrat, de préférence l'une des deux, peut constituer, ou comprendre, la couche d'oxyde. La couche en un matériau diélectrique de chaque substrat est de préférence autre qu'une couche d'oxyde natif du substrat. La couche d'oxyde est de préférence autre qu'une couche d'oxyde natif du substrat.

Selon un exemple, le procédé comprend en outre, entre la formation de la couche de collage et la mise en contact du premier substrat et du deuxième substrat, un traitement pour rendre les deux surfaces de collage hydrophiles, puis l'application d'eau sur lesdites deux surfaces de collage afin d'y former un film d'eau.

Selon un exemple, le procédé comprend en outre, après la mise en contact du premier substrat et du deuxième substrat, une étape d'amincissement du premier substrat de sorte à transférer une couche mince du premier substrat sur le deuxième substrat.

Selon un exemple, le procédé comprend en outre, suite à la mise en contact du premier substrat et du deuxième substrat, une étape de cristallisation d'au moins une partie de l'épaisseur de la couche de collage par traitement thermique. L'étape de cristallisation peut être réalisée par recuit laser ou par recuit thermique rapide (ou RTA acronyme du terme anglo-saxon « Rapid Thermal Anneal »).

Selon un exemple, la couche de collage est contrainte en tension ou en compression.

Selon un exemple, une première couche de collage est réalisée sur la première surface principale et une deuxième couche de collage est réalisée sur la deuxième surface principale.

Selon l'exemple précédent, les première et deuxième couches de collage peuvent comporter des éléments dopants différents en type (N ou P) et/ou en nature et/ou en concentration. En alternative ou en complément, l'épaisseur d'au moins une des première et deuxième couches de collage est inférieure à 10 nm, voire inférieure à 6 nm. La couche d'oxyde est de préférence située sous celle qui parmi les première et deuxième couches de collage a une épaisseur inférieure à 10 nm, voire inférieure à 6 nm.

Selon un exemple, le collage direct est réalisé à température et pression ambiantes.

Selon un exemple, la couche de collage est à base d'un matériau choisi parmi : le silicium et le germanium.

Selon un exemple, le procédé est exempt d'une étape de polissage mécano-chimique, notamment avant la mise en contact du premier substrat et du deuxième substrat.

On entend par une couche à base d'un matériau A, une couche comprenant ce matériau A et éventuellement d'autres matériaux.

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

Certaines parties, prenant par exemple la forme d'une couche, peuvent avoir une fonction électrique. Certaines sont employées pour des propriétés de conduction électrique et on entend par électriquement conducteurs ou équivalents, des éléments formés d'au moins un matériau ayant une conductivité suffisante, dans l'application, pour réaliser la fonction souhaitée. D'autres parties, au contraire, sont employées pour des propriétés d'isolation électrique et présentent une résistivité suffisante pour réaliser cette isolation ; elles sont notamment appelées diélectriques ou électriquement isolants. Typiquement, une couche électriquement conductrice aura une résistivité à 300°K inférieure à 10 mΩ.cm, voire inférieure à 100 mΩ.cm.

Les gammes de dopage, exprimées en concentration volumétrique, préférentiellement associées aux différents types de dopage indiqués dans la présente demande sont les suivantes :
- dopage p++ ou n++ : supérieur à 1 × 10²⁰ cm⁻³
- dopage p+ ou n+ : 1 × 10¹⁸ cm⁻³ à 9 × 10¹⁹ cm⁻³
- dopage p ou n : 1 × 10¹⁷ cm⁻³ à 1 × 10¹⁸ cm⁻³

Un dopage intrinsèque est associé à la gamme de dopage suivante : 1.10¹⁵ cm⁻³ à 1.10¹⁷ cm⁻³

Les exemples de réalisation décrits dans la suite indiquent un dopage « de type N ou de type P ». Un dopage de type N comprend un dopage n, n+ ou n++, et un dopage de type P comprend un dopage p, p+ ou p++. On parlera dans ce document de dopage pour désigner indifféremment un dopage de type N ou de type P.

Pour un matériau semi-conducteur du groupe IV comme le diamant, le silicium, le germanium, le carbure de silicium et le silicium germanium, les éléments dopants les plus courants sont les accepteurs du groupe III ou les donneurs d'éléments du groupe V. Par exemple, pour un matériau à base de silicium, on peut citer, comme donneurs, le phosphore, l'arsenic, l'antimoine, le bismuth et le lithium pour un dopage de type N et on peut citer, comme accepteurs, le bore, l'aluminium, le gallium et l'indium pour un dopage de type P.

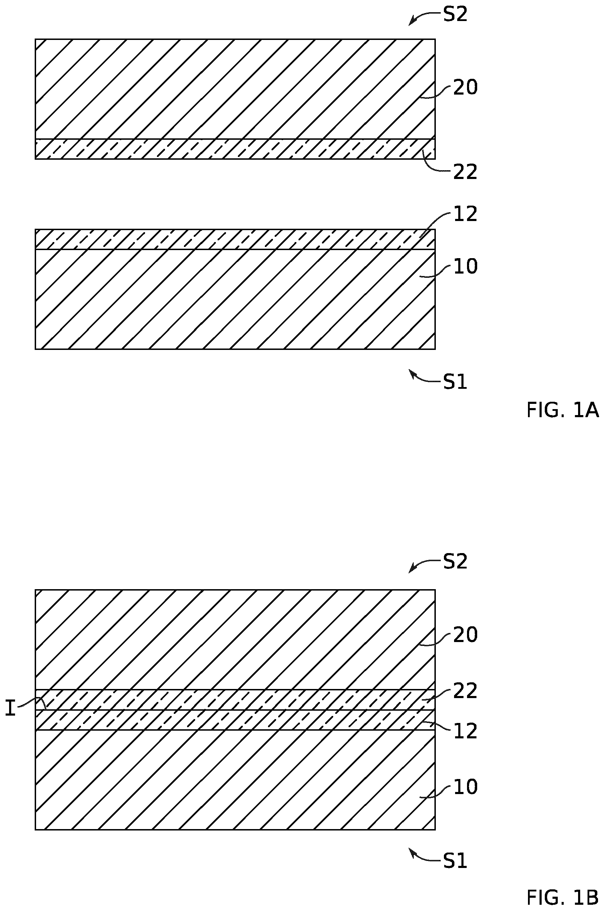

Les figures 1A à 1C illustrent des étapes successives d'un procédé selon un premier mode de réalisation de l'invention.

En référence à la figure 1A, on fournit un premier substrat S1 et un deuxième substrat S2 à coller le long d'une de leurs faces principales.

Selon un mode de réalisation, le premier substrat S1 et le deuxième substrat S2 sont des substrats semi-conducteurs, c'est-à-dire comprenant au moins une couche à base d'un matériau semi-conducteur 10, 20, tel que par exemple du silicium, du germanium, du silicium germanium ou du carbure de silicium. Avantageusement, il s'agit d'un matériau semi-conducteur monocristallin. L'un au moins parmi le premier substrat S1 et le deuxième substrat S2 peut comprendre une couche d'oxyde destinée à être disposée à moins de 20 nm, et avantageusement à moins de 10 nm, voire à moins de 6 nm, d'une interface de collage I entre les substrats.

Comme cela apparaîtra clairement au vu des autres modes de réalisation décrits plus bas, l'un au moins, voire chacun, des substrats S1 et S2 peut éventuellement comprendre d'autres matériaux, Notamment, l'un au moins, voire chacun, des substrats S1 et S2 comprend une couche d'un matériau électriquement isolant, tel que l'oxyde du matériau semi-conducteur de la couche 10, 20. La couche d'oxyde peut être constituée par, ou être comprise dans, une couche d'un matériau électriquement isolant.

D'une manière générale, l'invention s'applique à tout substrat compatible avec un collage direct hydrophile. Certains substrats sont naturellement hydrophiles ; ceux qui ne le sont pas peuvent subir un traitement pour rendre au moins leur surface de collage hydrophile, comme exposé plus bas.

Avant la mise en contact des substrats S1 et S2, on forme, de préférence à basse température (par exemple entre 200°C et 600°C), sur la face principale d'au moins un des deux substrats, une couche 12, 22 de collage en un matériau semi-conducteur amorphe comportant des éléments dopants dont la face libre formera une des surfaces de collage.

Dans l'exemple illustré sur la figure 1A, une couche de collage 12 est déposée sur une face principale du premier substrat S1 et une couche de collage 22 est déposée sur une face principale du deuxième substrat S2. Ces deux couches peuvent être formées de matériaux semi-conducteurs différents, et/ou avoir des épaisseurs ou comprendre des éléments dopants différents, en type (N ou P) et/ou en nature et/ou en concentration. Toutefois, de manière alternative, une unique couche de collage de matériau semi-conducteur amorphe contenant des éléments dopants 12, 22 pourrait être déposée sur l'un quelconque des deux substrats S1 et S2. Dans ce cas, la surface de collage en regard pourra être une surface de semi-conducteur monocristallin, ou la surface d'une couche de diélectrique (avantageusement un oxyde du semi-conducteur sous-jacent, et notamment un oxyde thermique) ou encore la surface d'une couche de matériau semi-conducteur amorphe ne contenant pas d'élément dopant.

La couche 12, 22 de collage en un matériau semi-conducteur amorphe comportant des éléments dopants peut être obtenue par différentes techniques. On peut déposer une couche amorphe notamment par CVD (pour « dépôt chimique en phase vapeur »), par PECVD (pour « CVD assisté par plasma »), par LPCVD (pour « CVD sous basse pression »), par PVD (pour « dépôt physique par phase vapeur »), par ALD (pour « dépôt de couches minces atomiques »), par IBS (pour « pulvérisation par faisceau d'ions »), par MBE (pour « épitaxie par faisceau moléculaire ») ou encore par EBE (pour « épitaxie par faisceau électronique »). Il est possible également de déposer une couche cristalline ou polycristalline, puis de venir l'amorphiser par exemple par implantation. De sorte que le matériau semi-conducteur amorphe de la couche 12, 22 de collage comprenne des éléments dopants, on pourra y implanter notamment les espèces suivantes : Si, Ge, As, P avec des doses allant de 5e14 à 1e16 ; le nombre, l'énergie et la dose d'implantation seront choisis pour obtenir l'épaisseur de couche amorphe recherchée.

L'ajout des éléments dopants dans la couche 12, 22 de collage en un matériau semi-conducteur amorphe peut être réalisé pendant le dépôt de ladite couche ou après son dépôt par implantation ionique.

Il pourra avantageusement s'agir d'une couche de silicium amorphe ou de germanium amorphe ou de silicium germanium amorphe, qui pourra contenir ou non d'autres espèces et notamment de l'hydrogène ou du carbone.

Cette couche pourra éventuellement être contrainte en tension ou en compression, par exemple avec une contrainte comprise entre 100 et 2000 MPa, ce qui pourra faciliter le fluage de cette couche lors du traitement thermique de fermeture de l'interface de collage. Cette contrainte pourra être obtenue par implantation ou pendant le dépôt du fait des conditions de dépôt utilisées. On pourra par exemple se référer à l'article de Johlin et al. intitulé « Stress engineering in amorphous silicon thin films » et publié en 2011 dans la 37ème édition du 'IEEE Photovoltaic Specialists Conférence' pour adapter le stress d'une couche de silicium amorphe déposée par PECVD.

L'épaisseur de chaque couche de collage 12, 22 peut être inférieure ou égale à 50 nm. Elle sera par exemple sensiblement comprise entre 1 et 50 nm, de préférence entre 3 et 20 nm, voire entre 3 et 10 nm. L'épaisseur peut être différente entre les deux couches de collage 12 et 22. Si une unique couche de collage est utilisée (sur S1 ou S2), son épaisseur pourra aller jusque 100 nm, mais sera avantageusement inférieure à 50 nm, voire à inférieure 20 nm. Si deux couches de collage sont utilisées et que l'une est épaisse (typiquement supérieure à 20 ou 50 nm), l'autre sera avantageusement d'épaisseur inférieure à 10 nm, voire inférieure à 6 nm. L'épaisseur de la couche de collage ou de chaque couche de collage est de préférence à apprécier relativement à la position relative de la couche d'oxyde. Plus particulièrement, le fait que la couche d'oxyde est disposée à moins de 20 nm, et avantageusement à moins de 10 nm, voire à moins de 6 nm, de l'interface de collage, peut conditionner l'épaisseur d'au moins une couche de collage 12, 22.

Selon un mode de réalisation avantageux, notamment lorsque les matériaux présents sur la face principale des substrats S1, S2 sont du silicium ou de l'oxyde de silicium, le matériau de la couche de collage 12, 22 est du silicium amorphe ou du germanium amorphe ou du silicium germanium amorphe.

Le dépôt d'une couche de collage 12, 22 constituée à base de silicium amorphe peut être effectué comme suit.

La surface du substrat qui est destinée à recevoir la couche de silicium amorphe est nettoyée au moyen d'une solution oxydante, par exemple du type O3/HF/O3 ou O3/HF/SC1. Le substrat est placé dans un bâti d'épitaxie porté à une température relativement basse en présence d'un précurseur tel que le disilane (Si2H6). La température de dépôt peut être comprise entre 475 et 550°C. La vitesse de croissance peut être de 5 à 10 nm/min. Selon un autre mode de réalisation, le précurseur utilisé est le silane (SiH4) ; la vitesse de croissance peut alors être plus faible. Selon d'autres modes de réalisation, le précurseur est un précurseur liquide de formule SiₙH₂ₙ₊₂ où n est un entier supérieur à 2, nécessitant l'utilisation d'un barboteur ; la température de dépôt peut être de l'ordre de 425 à 450°C. Des températures de dépôt plus basses (comprises entre 100 et 400°C) peuvent également être envisagées. On pourra se référer à l'article de Christou et al. initulé « Solid phase epitaxial regrowth of amorphous silicon on molecular beam epitaxial silicon/Si layers » et publié en 1983 dans 'Appl. Phys. Lett. 42, 1021'.

La figure 1B illustre la mise en contact des substrats S1 et S2 par l'intermédiaire des couches de collage 12 et 22. Le collage direct hydrophile s'opère alors. Il est avantageusement réalisé à température ou pression ambiante.

Un collage direct hydrophile est en général moins contraignant en termes de mise en oeuvre qu'un collage direct hydrophobe. Cependant, un tel collage direct hydrophile nécessite généralement la mise en oeuvre d'un traitement hydrophile au moins des faces destinées à être mises en contact. Un tel traitement hydrophile peut comprendre un nettoyage de type SC1, puis un rinçage à l'eau. A l'issue de ce traitement, chacune des surfaces destinées à être mises en contact est recouverte d'une fine pellicule d'eau (d'une épaisseur de l'ordre de 2 ou 3 monocouches).

Pour que le collage direct hydrophile puisse s'opérer, il faut que les surfaces qui viennent en contact soient suffisamment lisses. Si nécessaire, un polissage mécano-chimique (CMP) pourra être réalisé avant collage pour cela. Avantageusement, un tel polissage ne sera pas nécessaire si la (ou les) couche(s) amorphe(s) contenant des éléments dopants est (sont) déposé(es) sur un substrat S1 (et/ou S2) lui-même suffisamment lisse ou si le collage a lieu sur une surface d'oxyde de silicium issue d'une oxydation thermique du substrat S1 (ou S2) monocristallin suffisamment lisse. Ladite surface d'oxyde peut constituer une surface de la couche d'oxyde.

Bien que lisses, les surfaces destinées à être collées entre elles présentent des aspérités au niveau desquelles se produit le contact entre les substrats S1 et S2. Des cavités s'étendent entre ces aspérités, de sorte que l'interface I n'est pas fermée par simple mise en contact des substrats S1 et S2 entre eux.

La figure 1B illustre la structure obtenue à l'issue du traitement thermique de fermeture de l'interface de collage I.

Le traitement thermique peut durer par exemple entre 30 min et 10h en fonction de la température de recuit et des couches présentes à l'interface de collage. La température de recuit pourra par exemple être plus basse en présence de germanium amorphe à l'interface par rapport à celle en présence de silicium amorphe à l'interface.

La température du traitement thermique et la vitesse de montée en température peuvent être définies par l'homme du métier, par exemple à partir de tests de fermeture de l'interface I de plusieurs structures identiques traitées avec des traitements thermiques différents. Ces tests pourront par exemple être basés sur des mesures de résistance à l'attaque chimique à l'interface de collage. Pour des applications nécessitant un faible budget thermique, on sélectionnera de préférence la température la plus basse parmi les températures qui conduisent à une fermeture complète de l'interface de collage I.

Selon un exemple, le traitement thermique est mis en oeuvre à une température sensiblement inférieure ou égale à 900°C, de préférence inférieure ou égale à 600°C.

Ce traitement thermique peut permettre le fluage des couches présentes à l'interface de collage et a minima du fait de la mobilité atomique à l'interface de collage permet de faire disparaître les cavités présentes à cette interface et ainsi permet la fermeture complète de l'interface de collage. Le collage étant hydrophile, une réaction chimique se produit également entre l'eau et le matériau semi-conducteur présent à l'interface de collage I pendant ce traitement thermique. Cette réaction conduit au dégagement de dihydrogène.

Dans le cas d'un collage hydrophile oxyde / silicium, la réaction chimique s'écrit :

2 H₂O + Si → SiO₂ + 2 H₂

En d'autres termes, l'eau présente à l'interface de collage I traverse l'oxyde natif présent sur le silicium (cet oxyde natif étant différent de la couche d'oxyde) et oxyde ledit silicium. Ce phénomène se produit dès 150°C et conduit au dégagement de dihydrogène, qui diffuse dans la couche d'oxyde située le cas échéant de l'autre côté de l'interface de collage. Si ladite couche d'oxyde est trop fine ou qu'il existe une barrière de diffusion entre l'interface de collage et la couche d'oxyde, le dihydrogène peut rouvrir l'interface de collage en formant des bulles. Pour éviter cela, la couche d'oxyde sera de préférence disposée à moins de 20 nm (et avantageusement moins de 10 nm, voire moins de 6 nm) de l'interface de collage. On pourra se référer à cet égard à la publication de S. Vincent et al. intitulée « A model of interface defect formation in silicon wafer bonding » et publié dans la revue Applied Physics Letters (94, 101914 (2009)).

On pouvait donc craindre que la couche de collage amorphe constitue une telle barrière et conduise à une défectivité importante de la structure collée.

Toutefois, de manière surprenante, une telle défectivité n'est pas générée pour une structure collée avec une ou des couches de collage amorphe contenant des éléments dopants 12 et 22 telles que décrites ci-dessus. On peut donc considérer que la ou les couches de collage 12 et 22 telles que décrites ci-dessus sont notamment suffisamment fines ou perméables au dihydrogène pour permettre la diffusion du dihydrogène vers la couche d'oxyde enterrée, assurant ainsi un collage de bonne qualité.

Notons ici qu'il est envisagé qu'une seule des deux couches de collage 12 et 22 comprenne des éléments dopants ; dans ce cas :
- la concentration en élément(s) dopant(s) de la couche de collage peut être augmentée relativement au cas où les deux couches de collage 12 et 22 comprennent des éléments dopants et/ou
- l'épaisseur de la couche de collage ne comprenant pas d'élément dopant peut être réduite, par exemple pour être comprise entre 1 et 6 nm, de sorte à s'assurer de la diffusion du dihydrogène comme discutée ci-dessus.

Suite à l'étape de mise en contact et lors de l'étape de traitement thermique, chaque couche de collage 12, 22 à base d'un matériau semi-conducteur amorphe peut être convertie, sur une partie de son épaisseur, en oxyde de ce matériau par réaction avec l'eau de collage au niveau de sa surface formant au moins en partie l'interface de collage I.

Lorsqu'une seule couche de collage 12 est prévue sur le premier substrat S1, la partie de la couche de collage convertie en oxyde peut être combinée avec une couche d'oxyde natif du deuxième substrat S2 pour former une couche d'oxyde. Cette couche d'oxyde en partie natif est de préférence différente de, voire est prolongée par, la couche d'oxyde disposée à moins de 20 nm (et avantageusement moins de 10 nm, voire moins de 6 nm) de l'interface de collage.

Selon une variante, on évitera que ce phénomène ne transforme l'intégralité de l'épaisseur de la ou des couches de collage 12, 22 à base d'un matériau semi-conducteur amorphe en son oxyde au cours du traitement thermique de fermeture de l'interface de collage I. On peut à cet effet choisir l'épaisseur de la couche de collage 12, 22 à base d'un matériau semi-conducteur amorphe suffisamment élevée pour que la réaction avec l'eau de collage ne la consomme pas entièrement. A cette fin, chaque couche de collage présente de préférence une épaisseur minimale sensiblement égale ou supérieure à 4 nm. Ainsi, chaque couche de collage présente de préférence une épaisseur sensiblement comprise entre 5 nm et 20 à 50 nm.

Comme illustré sur la figure 1B, suite à l'application du traitement thermique de fermeture de l'interface de collage I, l'assemblage obtenu comprend successivement :
- Le premier substrat S1,
- les couches de collage à base d'un matériau semi-conducteur amorphe contenant des éléments dopants, et
- Le deuxième substrat S2,

L'un au moins parmi le premier substrat S1 et le deuxième substrat S2 comprenant la couche d'oxyde disposée à moins de 20 nm, et avantageusement à moins de 10 nm, voire à moins de 6 nm, de l'interface de collage.

Au niveau de l'interface de collage I, l'assemblage peut également comprendre (de façon non représentée sur la figure 1B) au moins une fine couche d'oxyde du matériau semi-conducteur amorphe présent au niveau de cette interface de collage I, cette fine couche d'oxyde ayant été générée par réaction avec l'eau de collage de la façon décrite ci-dessus.

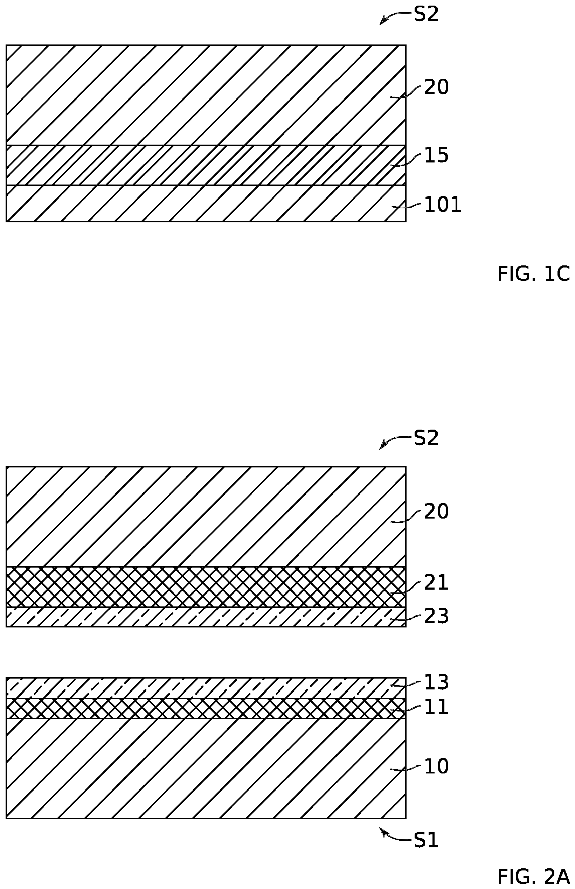

La figure 1C illustre la structure obtenue, à l'issue d'une étape de cristallisation des couches de collage à base d'un matériau semi-conducteur amorphe contenant des éléments dopants 12, 22 présentes à l'interface de collage I et d'une étape d'amincissement du premier substrat S1 qui sont décrites ci-après.

Cette cristallisation peut être obtenue directement au cours du traitement thermique de fermeture de l'interface de collage si la température de ce traitement est suffisamment élevée ou peut nécessiter un traitement thermique additionnel. Elle va s'accompagner d'une activation des éléments dopants présents pour former une couche à base d'un matériau semi-conducteur polycristallin et dopé constituant une couche conductrice 15 au sein de la structure assemblée.

Pour des applications nécessitant une limitation du budget thermique, l'étape de cristallisation (et/ou d'activation du ou des éléments dopants) des couches de collage à base d'un matériau semi-conducteur amorphe contenant des éléments dopants 12, 22 peut être réalisée par au moins un recuit laser ou par tout autre technique présentant un budget thermique encore plus bas. En alternative (notamment pour des applications sans limitation particulière de budget thermique) ou en complément, l'étape de cristallisation peut impliquer un recuit de type recuit rapide (communément désigné par l'acronyme RTA, de l'anglais « Rapid Thermal Annealing ») ou de type recuit flash (de l'anglais « flash annealing »).

Plus particulièrement, la cristallisation sous forme polycristalline des couches amorphes de collage peut être réalisée, ou à tout le moins initiée, au moyen d'un recuit laser qui vient typiquement induire une cristallisation selon un régime de cristallisation dite explosive. Pour ce faire, la surface principale exposée du premier substrat S1 et/ou du deuxième substrat S2 peut être soumise à une irradiation laser, de préférence une irradiation impulsionnelle, typiquement une irradiation avec une durée inférieure à la microseconde, par exemple de 200 nanosecondes, qui vient initier la cristallisation. Au besoin, ce recuit laser peut être suivi d'un traitement thermique complémentaire et/ou d'un ou plusieurs recuits lasers complémentaires venant promouvoir le développement de la microstructure polycristalline générée par le recuit laser initial. Le traitement thermique complémentaire peut typiquement aller de 10 minutes à 500°C jusqu'à 2s à 1100°C. Les recuits lasers complémentaires (au besoin jusqu'à 100 recuits) sont quant à eux réalisés de manière à ne pas permettre la fusion des matériaux en présence.

La cristallisation peut avoir lieu comme illustrée en figure 1C sur toute l'épaisseur des couches de collage amorphes 12 et 22 ou seulement sur une partie de l'épaisseur de ces couches.

L'étape d'amincissement du premier substrat S1 est réalisée par la face du premier substrat S1 qui est opposée à l'interface de collage I. Cette étape d'amincissement peut impliquer au moins un procédé d'amincissement, tel que le procédé Smart Cut^{™}, le procédé connu sous l'acronyme BESOI pour « Silicium sur isolant par collage et gravure arrière » selon la terminologie anglo-saxonne, ou une gravure. Elle peut être réalisée avant ou après le traitement thermique de fermeture de l'interface.

De préférence, et notamment lorsque l'étape de cristallisation implique un recuit laser par la face du premier substrat S1 qui est opposée à l'interface de collage I, l'étape d'amincissement est réalisée avant l'étape de cristallisation.

Il est à noter que la cristallisation peut n'être réalisée qu'en une ou plusieurs zones localisées de la couche de collage, une ou plusieurs autres zones n'étant pas soumises à une telle transformation. Le recuit laser de recristallisation peut pour cela être réalisé à travers un masque. Les régions rendues polycristallines sont alors obtenues au niveau de la zone irradiée par le laser au droit des ouvertures du masque. Les régions amorphes non irradiées par le laser peuvent rester amorphes ou être rendues monocristallines par un traitement adapté, par exemple par un recuit de recristallisation en phase solide dit de SPER si cette couche amorphe est en contact avec un semi-conducteur monocristallin.

Comme illustré sur la figure 1C, suite à l'étape de cristallisation et à l'étape d'amincissement du premier substrat S1, l'assemblage obtenu peut comprendre successivement :
- Une couche mince 101 issue du premier substrat S1,
- Une couche à base d'un matériau semi-conducteur polycristallin dopé 15, et
- Le deuxième substrat S2,

L'un au moins parmi la couche mince 101 et le deuxième substrat S2 comprenant le cas échéant la couche d'oxyde disposée à moins de 20 nm, et avantageusement à moins de 10 nm, voire à moins de 6 nm, de l'interface de collage.

Ainsi, une couche mince 101 du premier substrat a été transférée sur le deuxième substrat S2.

Les figures 2A à 2C illustrent des étapes successives d'un procédé selon un deuxième mode de réalisation de l'invention. Sont plus particulièrement décrites ci-dessous les caractéristiques du procédé selon le deuxième mode de réalisation de l'invention qui le distinguent du procédé décrit en référence aux figures 1A à 1C.

Comme illustré sur la figure 2A, le premier substrat S1 et le deuxième substrat S2 tels que fournis comprennent chacun une couche à base d'un matériau semi-conducteur 10, 20, avantageusement monocristallin, une couche à base d'un matériau diélectrique 11, 21, typiquement à base de l'oxyde du matériau semi-conducteur de la couche 10, 20 et, au moins l'un parmi le premier substrat S1 et le deuxième substrat S2 tels que fournis comprend une couche d'oxyde disposée à moins de 20 nm, et avantageusement à moins de 10 nm, voire à moins de 6 nm, de l'interface de collage. Le cas échéant, la couche d'oxyde peut être constituée par, ou être comprise dans, la couche en un matériau diélectrique 11, 21.

Comme dans le premier mode de réalisation de l'invention, outre le silicium, d'autres matériaux semi-conducteurs tels que le germanium, le silicium-germanium ou le carbure de silicium sont envisagés.

Chaque couche diélectrique 11, 21 est de préférence formée par oxydation thermique du matériau semi-conducteur constituant le substrat correspondant. En alternative, chaque couche diélectrique 11, 21 peut avoir été déposée sur une des faces principales du substrat correspondant, par exemple par PECVD ou ALD.

On rappelle qu'une couche d'oxyde thermique diffère d'une couche d'oxyde natif par son épaisseur (la couche d'oxyde natif étant beaucoup plus fine que la couche d'oxyde thermique). La couche d'oxyde natif est présente naturellement à la surface d'un substrat, et n'est pas nécessairement destinée à remplir une fonction d'isolation électrique au sein de la structure obtenue par collage des deux substrats, contrairement à une couche d'oxyde thermique telle que considérée ici.

En alternative, chaque couche diélectrique 11, 21 peut être constituée à base de nitrure de silicium. Elle peut dans ces cas être déposée par PECVD, ou LPCVD ou encore parALD notamment.

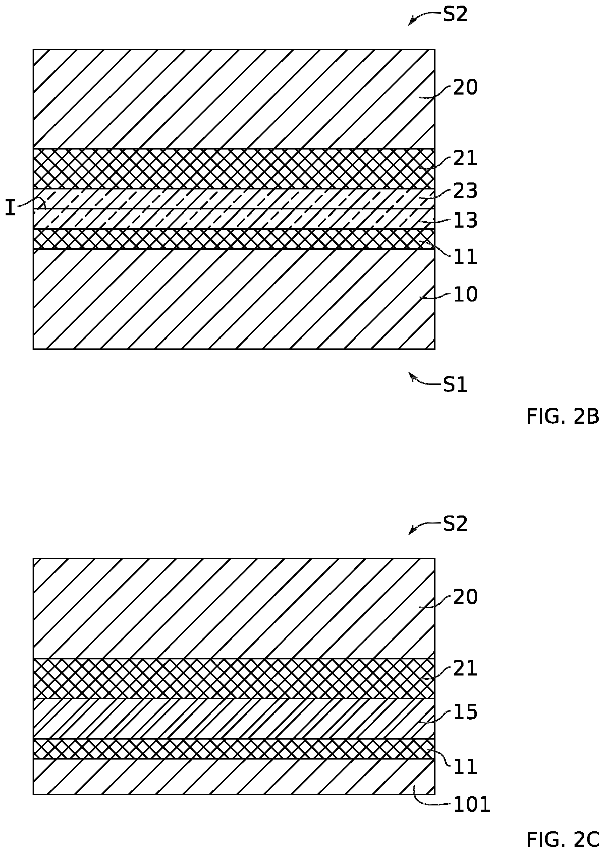

Les étapes subséquentes de mise en contact et d'application du traitement thermique de fermeture de l'interface de collage I peuvent alors être réalisées de la façon décrite plus haut en relation avec le premier mode de réalisation de l'invention, une couche de collage 13, 23 en un matériau semi-conducteur amorphe comportant des éléments dopants étant prévue sur l'un au moins des substrats S1 et S2 au niveau de leur face à assembler. L'étape de mise en contact mène alors à la structure illustrée que la Figure 2B. L'étape de mise en contact peut encore être suivie, simultanément ou postérieurement à l'application du traitement thermique de fermeture de l'interface, de l'étape de cristallisation et éventuellement de l'étape d'amincissement de la façon décrite plus haut en relation avec le premier mode de réalisation de l'invention pour conduire à une structure telle qu'illustrée sur la figure 2C.

Comme illustré sur la figure 2C, si la cristallisation a lieu sur toute l'épaisseur des couches de collage 13, 23et suite à l'étape d'amincissement du premier substrat S1 et d'activation des dopants, l'assemblage obtenu peut comprendre successivement :
- Une couche mince 101 issue du premier substrat S1,
- Une couche diélectrique 11,
- Une couche à base d'un matériau semi-conducteur polycristallin et dopé 15,
- Une couche diélectrique 21, et
- Le deuxième substrat S2,

L'un au moins parmi la couche mince 101 et le deuxième substrat S2 comprenant le cas échéant la couche d'oxyde disposée à moins de 20 nm, et avantageusement à moins de 10 nm, voire à moins de 6 nm, de l'interface de collage.

La couche à base d'un matériau semi-conducteur polycristallin et dopé 15 forme ainsi une couche conductrice enterrée dans la structure et est susceptible d'être polarisée et électriquement isolée de la couche mince 101 et du deuxième substrat S2 respectivement par les couches diélectriques 11 et 21.

Au niveau de l'interface de collage I, l'assemblage peut également comprendre (de façon non représentée sur la figure 2C) au moins une fine couche d'oxyde du matériau semi-conducteur amorphe présent au niveau de cette interface de collage I comme expliqué précédemment. Cette fine de couche d'oxyde est différente la couche d'oxyde disposée à moins de 20 nm, et avantageusement à moins de 10 nm, voire à moins de 6 nm, de l'interface de collage ; toutefois, la fine de couche d'oxyde peut être prolongée par la couche d'oxyde disposée à moins de 20 nm, et avantageusement à moins de 10 nm, voire à moins de 6 nm, de l'interface de collage.

Si la cristallisation n'est que sur une partie de l'épaisseur des couches de collage 13, 23, des couches amorphes subsisteront dans la structure.

On observe que la structure illustrée sur la figure 2C est comparable à celle illustrée sur la figure 4. Le procédé selon le deuxième mode de réalisation de l'invention conduit ainsi à une structure adaptée à l'intégration monolithique en 3D de composants microélectroniques.

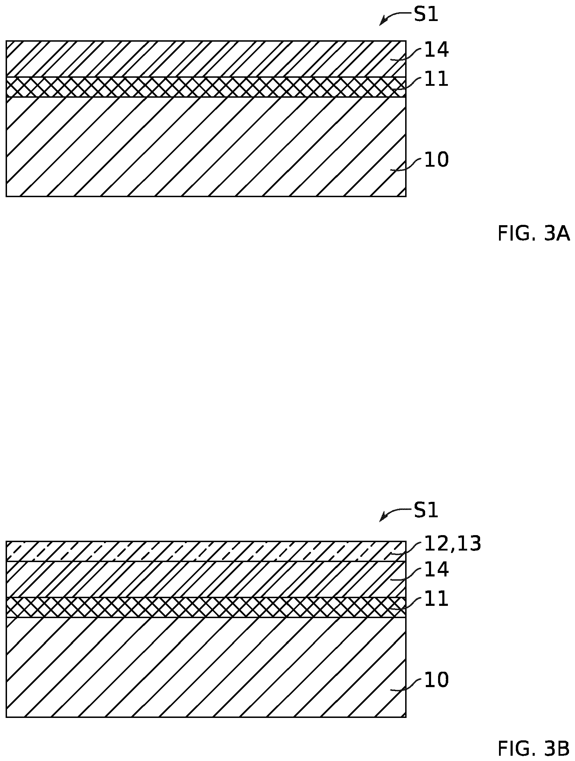

Les figures 3A à 3D illustrent des étapes successives d'un procédé selon un troisième mode de réalisation de l'invention. Sont plus particulièrement décrites ci-dessous les caractéristiques du procédé selon le troisième mode de réalisation de l'invention qui le distinguent du procédé décrit en référence aux figures 2A à 2C.

Le troisième mode de réalisation de l'invention diffère essentiellement du deuxième mode de réalisation de l'invention décrit ci-dessus en ce qu'une couche dite polycristalline 14 à base d'un matériau semi-conducteur polycristallin et présentant un dopage de type N ou de type P est formée sur la surface principale du premier substrat S1 (en variante ou en complément elle pourrait être formée sur le deuxième substrat S2). La couche polycristalline dopée14 présente de préférence une épaisseur sensiblement comprise entre 1 et 50 nm, de préférence entre 3 et 20 nm, voire entre 3 et 10 nm.

La couche polycristalline dopée 14 peut être formée par dépôt, par exemple par PVD ou CVD ou ALD. Elle peut en alternative être formée par dépôt d'une couche amorphe dudit matériau semi-conducteur, puis par cristallisation de cette couche amorphe, par exemple par recuit laser ou tout autre recuit décrit précédemment. Cette cristallisation de la couche amorphe à partir de laquelle la couche polycristalline 14 est formée peut également être réalisée après la formation d'une couche amorphe 12, 13 telle que décrite ci-après. La cristallisation de ladite couche amorphe peut plus particulièrement être réalisée lors de l'étape de cristallisation de cette couche amorphe 12, 13.

La couche amorphe 12, 13 telle qu'illustrée sur la figure 3B peut être réalisée par une étape d'amorphisation d'une partie de l'épaisseur de la couche polycristalline 14, notamment lorsque cette dernière est à base de silicium polycristallin. L'étape d'amorphisation est de préférence réalisée depuis une surface exposée de la couche polycristalline 14, par exemple par implantation ionique. La couche amorphe 12, 13 présente de préférence une épaisseur sensiblement comprise entre 1 et 5 nm.

En alternative, la couche amorphe 12, 13 telle qu'illustrée sur la figure 3B peut être déposée sur la face exposée de la couche polycristalline 14, par exemple de la façon discutée plus haut relative au dépôt de la couche de collage 12 selon le premier mode de réalisation de l'invention.

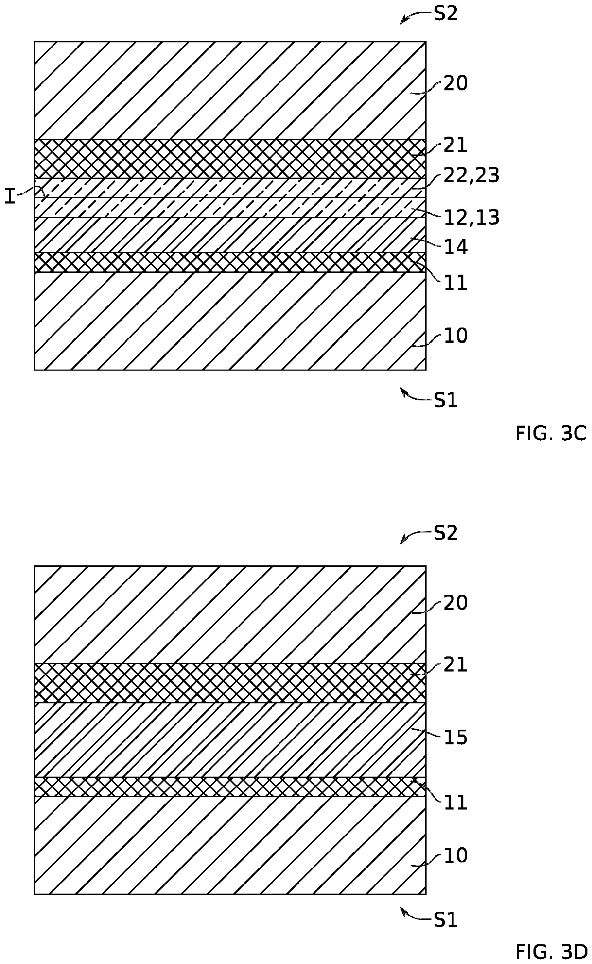

Le deuxième substrat S2 fourni peut être identique à S1 ou identique au deuxième substrat S2 décrit ci-dessus en relation avec le deuxième mode de réalisation de l'invention. L'étape de mise en contact conduit dans ce dernier cas à une configuration telle qu'illustrée sur la figure 3C, tandis que l'application du traitement thermique de fermeture de l'interface de collage I et l'étape de cristallisation conduisent à une structure telle qu'illustrée sur la figure 3D.

Comme illustré sur la figure 3D, si la cristallisation est opérée sur toute l'épaisseur des couches de collage 13, 23, l'assemblage obtenu peut comprendre successivement :
- Le premier substrat S1,
- Une couche diélectrique 11,
- Une couche à base d'un matériau semi-conducteur polycristallin dopé 15,
- Une couche diélectrique 21, et
- Le deuxième substrat S2

L'un au moins parmi le premier substrat S1 et le deuxième substrat S2 comprenant la couche d'oxyde disposée à moins de 20 nm, et avantageusement à moins de 10 nm, voire à moins de 6 nm, de l'interface de collage.

La couche à base d'un matériau semi-conducteur polycristallin dopé 15 formant couche conductrice enterrée au sein de l'empilement est ici issue des couches de collage 12, 13 et 22, 23 et de la couche polycristalline 14.

Au niveau de l'interface de collage I, l'assemblage peut également comprendre (de façon non représentée sur la figure 3D) au moins une fine couche d'oxyde du matériau semi-conducteur amorphe comme expliqué précédemment. Cette fine de couche d'oxyde est différente la couche d'oxyde disposée à moins de 20 nm, et avantageusement à moins de 10 nm, voire à moins de 6 nm, de l'interface de collage ; toutefois, la fine de couche d'oxyde peut être prolongée par la couche d'oxyde disposée à moins de 20 nm, et avantageusement à moins de 10 nm, voire à moins de 6 nm, de l'interface de collage.

Une étape d'amincissement du premier substrat S1 peut encore être implémentée de la façon décrite ci-dessus en relation avec le premier mode de réalisation de l'invention.

Comme la structure illustrée sur la figure 2C, on obtient, par mise en oeuvre du procédé selon le troisième mode de réalisation de l'invention, une structure telle qu'illustrée sur la figure 3D adaptée à l'intégration monolithique en 3D de composants microélectroniques.

On note que, dans la mesure où la couche polycristalline 14 est déjà formée avant l'étape de cristallisation des couches de collage 12, 13 et 22, 23, cette étape de cristallisation n'est pas nécessaire à l'obtention d'une structure adaptée à l'intégration monolithique en 3D de composants microélectroniques, puisque la couche polycristalline 14 peut à elle seule constituer la couche électriquement conductrice 15.

L'invention n'est pas limitée aux modes de réalisations précédemment décrits et s'étend à tous les modes de réalisation dans le cadre des revendications en annexe.

## Revendications

1. Procédé de collage direct hydrophile d'un premier substrat (S1) sur un deuxième substrat (S2), comprenant :
• La fourniture d'un premier substrat (S1) présentant une première surface principale et d'un deuxième substrat présentant une deuxième surface principale,
• la mise en contact du premier substrat (S1) et du deuxième substrat (S2) du côté respectivement de leurs première et deuxième surfaces principales, de sorte à former une interface de collage (I) entre deux surfaces de collage,
• l'application d'un traitement thermique adapté pour fermer ladite interface de collage (I),
ledit procédé étant **caractérisé en ce qu'**il comprend, avant l'étape de mise en contact, la formation, sur la première surface principale et/ou sur la deuxième surface principale, d'une couche de collage (12, 13, 22, 23) en un matériau semi-conducteur amorphe comportant des éléments dopants et d'épaisseur inférieure ou égale à 50 nm, une face de ladite couche de collage constituant une des deux surfaces de collage, une couche d'oxyde étant disposée à moins de 20 nm de l'interface de collage.

2. Procédé selon la revendication précédente, dans lequel le traitement thermique est mis en oeuvre à une température sensiblement inférieure ou égale à 900°C, de préférence inférieure ou égale à 600°C.

3. Procédé selon l'une quelconque des revendications précédentes, dans lequel la formation de la couche de collage (12, 22) en un matériau semi-conducteur amorphe comportant des éléments dopants comprend une étape de dépôt dudit matériau semi-conducteur amorphe sur ladite surface principale du substrat (S1, S2) correspondant, les éléments dopants étant introduits dans la couche de collage lors du dépôt du matériau semi-conducteur amorphe ou après ce dépôt par implantation.

4. Procédé selon l'une quelconque des revendications 1 à 2, dans lequel la formation de la couche de collage (12, 13, 22, 23) en un matériau semi-conducteur amorphe comportant des éléments dopants (13) comprend :
• une étape de formation d'une couche dite polycristalline (14) à base d'un matériau semi-conducteur polycristallin sur ladite surface principale du substrat (S1, S2) correspondant, puis
• une étape d'amorphisation d'au moins une partie de l'épaisseur de la couche polycristalline (14), depuis une surface exposée de celle-ci, de sorte à former ladite couche de collage (13), cette dernière présentant de préférence une épaisseur sensiblement comprise entre 1 et 20 nm, et préférentiellement comprise entre 2 et 5 nm,
la couche polycristalline comprenant les éléments dopants ou ceux-ci étant introduits par implantation dans la couche de collage après l'étape d'amorphisation.

5. Procédé selon l'une quelconque des revendications 1 à 2, dans lequel la formation de la couche de collage (12, 22) en un matériau semi-conducteur amorphe comportant des éléments dopants comprend :
• une étape de formation d'une couche dite polycristalline (14) à base d'un matériau semi-conducteur polycristallin dopé sur ladite surface principale du substrat (S1) correspondant, puis
• une étape de dépôt du matériau semi-conducteur amorphe sur la couche polycristalline (14), les éléments dopants étant introduits dans la couche de collage lors du dépôt du matériau semi-conducteur amorphe ou après ce dépôt par implantation.

6. Procédé selon l'une quelconque des revendications précédentes, dans lequel le premier substrat (S1) et le deuxième substrat (S2) comprennent chacun une couche en un matériau semi-conducteur monocristallin (10, 20), l'un au moins des premier et deuxième substrats comportant une couche en un matériau diélectrique (11, 21) disposée sur la couche en un matériau semi-conducteur monocristallin, la première et/ou la deuxième surface principale étant formée par la face libre de la couche en un matériau diélectrique.

7. Procédé selon l'une quelconque des revendications précédentes, comprenant, entre la formation de la couche de collage (12, 22) et la mise en contact du premier substrat (S1) et du deuxième substrat (S2), un traitement pour rendre les deux surfaces de collage (S1, S2) hydrophiles, puis l'application d'eau sur lesdites deux surfaces de collage afin d'y former un film d'eau.

8. Procédé selon l'une quelconque des revendications précédentes, comprenant en outre, après la mise en contact du premier substrat (S1) et du deuxième substrat (S2), une étape d'amincissement du premier substrat (S1) de sorte à transférer une couche mince (101) du premier substrat sur le deuxième substrat (S2).

9. Procédé selon l'une quelconque des revendications, comprenant en outre, après à la mise en contact du premier substrat et du deuxième substrat, une étape de cristallisation d'au moins une partie de l'épaisseur de la couche de collage par traitement thermique.

10. Procédé selon la revendication précédente, dans lequel la teneur de la couche de collage (12, 22) en éléments dopants est paramétrée, au moins en termes de nature et de concentration des éléments dopants, de sorte que l'étape de cristallisation génère une couche polycristalline électriquement conductrice.

11. Procédé selon l'une quelconque des deux revendications précédentes, dans lequel l'étape de cristallisation est réalisée par recuit laser.

12. Procédé selon l'une quelconque des revendications précédentes, dans lequel la couche de collage (12, 22) est contrainte en tension ou en compression.

13. Procédé selon l'une quelconque des revendications précédentes, dans lequel une première couche de collage (12) est réalisée sur la première surface principale et une deuxième couche de collage (22) est réalisée sur la deuxième surface principale.

14. Procédé selon la revendication 13, dans lequel les première et deuxième couches de collage comportent des éléments dopants différents en type (N ou P) et/ou en nature et/ou en concentration.

15. Procédé selon l'une quelconque des revendications 13 et 14, dans lequel l'épaisseur d'au moins une des première et deuxième couches de collage (12, 22) est inférieure à 10 nm, voire inférieure à 6 nm.

## Patentansprüche

1. Verfahren zum direkten hydrophilen Bonden eines ersten Substrats (S1) an ein zweites Substrat (S2), umfassend:
• Bereitstellen eines ersten Substrats (S1), das eine erste Hauptfläche aufweist, und eines zweiten Substrats, das eine zweite Hauptfläche aufweist,
• Inkontaktbringen des ersten Substrats (S1) und des zweiten Substrats (S2) auf der Seite ihrer ersten bzw. zweiten Hauptfläche, um eine Bond-Grenzfläche (I) zwischen zwei Bondflächen zu bilden,
• Anwenden einer Wärmebehandlung, die geeignet ist, um die Bond-Grenzfläche (I) zu schließen,
wobei das Verfahren **dadurch gekennzeichnet ist, dass** es vor dem Schritt des Inkontaktbringens das Bilden einer Bondschicht (12, 13, 22, 23) aus einem Dotierelemente umfassenden amorphen Halbleitermaterial auf der ersten Hauptfläche und/oder auf der zweiten Hauptfläche und mit einer Dicke von kleiner oder gleich 50 nm umfasst, wobei eine Seite der Bondschicht eine der zwei Bondflächen darstellt, wobei weniger als 20 nm von der Bond-Grenzfläche eine Oxidschicht angeordnet ist.

2. Verfahren nach dem vorstehenden Anspruch, wobei die Wärmebehandlung bei einer Temperatur umgesetzt wird, die wesentlich kleiner oder gleich 900°C, vorzugsweise kleiner oder gleich 600°C ist.

3. Verfahren nach einem der vorstehenden Ansprüche, wobei das Bilden der Bondschicht (12, 22) aus einem Dotierelemente umfassenden amorphen Halbleitermaterial einen Schritt des Abscheidens des amorphen Halbleitermaterials auf der Hauptfläche des entsprechenden Substrats (S1, S2) umfasst, wobei die Dotierelemente beim Abscheiden des amorphen Halbleitermaterials oder nach diesem Abscheiden durch Implantation in die Bondschicht eingebracht werden.

4. Verfahren nach einem der Ansprüche 1 bis 2, wobei das Bilden der Bondschicht (12, 13, 22, 23) aus einem Dotierelemente umfassenden amorphen Halbleitermaterial (13) umfasst:
• einen Schritt des Bildens einer sogenannten polykristallinen Schicht (14) auf Basis eines polykristallinen Halbleitermaterials auf der Hauptfläche des entsprechenden Substrats (S1, S2), und anschließend
• einen Schritt des Amorphisierens mindestens eines Teils der Dicke der polykristallinen Schicht (14) von einer freiliegenden Fläche derselben her, um die Bondschicht (13) zu bilden, wobei diese letztere vorzugsweise eine Dicke von im Wesentlichen im Bereich zwischen 1 und 20 nm, und vorzugsweise im Bereich zwischen 2 und 5 nm aufweist,
wobei die polykristalline Schicht die Dotierelemente umfasst oder diese nach dem Schritt des Amorphisierens durch Implantation in die Bondschicht eingebracht werden.

5. Verfahren nach einem der Ansprüche 1 bis 2, wobei das Bilden der Bondschicht (12, 22) aus einem Dotierelemente umfassenden amorphen Halbleitermaterial umfasst:
• einen Schritt des Bildens einer sogenannten polykristallinen Schicht (14) auf Basis eines dotierten polykristallinen Halbleitermaterials auf der Hauptfläche des entsprechenden Substrats (S1), und anschließend
• einen Schritt des Abscheidens des amorphen Halbleitermaterials auf der polykristallinen Schicht (14), wobei die Dotierelemente beim Abscheiden des amorphen Halbleitermaterials oder nach diesem Abscheiden durch Implantation in die Bondschicht eingebracht werden.

6. Verfahren nach einem der vorstehenden Ansprüche, wobei das erste Substrat (S1) und das zweite Substrat (S2) jeweils eine Schicht aus einem monokristallinen Halbleitermaterial (10, 20) umfassen, wobei mindestens eines aus dem ersten und dem zweiten Substrat eine Schicht aus einem dielektrischen Material (11, 21) umfasst, die auf der Schicht aus einem monokristallinen Halbleitermaterial angeordnet ist, wobei die erste und/oder die zweite Hauptfläche von der freien Seite der Schicht aus einem dielektrischen Material gebildet wird.

7. Verfahren nach einem der vorstehenden Ansprüche, das zwischen dem Bilden der Bondschicht (12, 22) und dem Inkontaktbringen des ersten Substrats (S1) und des zweiten Substrats (S2) eine Behandlung, um die zwei Bondflächen (S1, S2) hydrophil zu machen, und anschließend das Aufbringen von Wasser auf die zwei Bondflächen umfasst, um dort einen Wasserfilm zu bilden.

8. Verfahren nach einem der vorstehenden Ansprüche, das nach dem Inkontaktbringen des ersten Substrats (S1) und des zweiten Substrats (S2) weiter einen Schritt des Ausdünnens des ersten Substrats (S1) umfasst, um eine Dünnschicht (101) des ersten Substrats auf das zweite Substrat (S2) zu transferieren.

9. Verfahren nach einem der Ansprüche, das nach dem Inkontaktbringen des ersten Substrats und des zweiten Substrats weiter einen Schritt des Kristallisierens mindestens eines Teils der Dicke der Bondschicht durch Wärmebehandlung umfasst.

10. Verfahren nach dem vorstehenden Anspruch, wobei der Gehalt der Bondschicht (12, 22) an Dotierelementen mindestens in Hinblick auf Art und Konzentration der Dotierelemente parametriert wird, damit der Schritt des Kristallisierens eine elektrisch leitende polykristalline Schicht erzeugt.

11. Verfahren nach einem der zwei vorstehenden Ansprüche, wobei der Schritt des Kristallisierens durch Laser-Ausglühen ausgeführt wird.

12. Verfahren nach einem der vorstehenden Ansprüche, wobei die Bondschicht (12, 22) zug- oder druckgespannt wird.

13. Verfahren nach einem der vorstehenden Ansprüche, wobei eine erste Bondschicht (12) auf der ersten Hauptfläche hergestellt wird, und eine zweite Bondschicht (22) auf der zweiten Hauptfläche hergestellt wird.

14. Verfahren nach Anspruch 13, wobei die erste und die zweite Bondschicht Dotierelemente umfassen, die sich im Typ (N oder P) und/oder in der Art und/oder in der Konzentration unterscheiden.

15. Verfahren nach einem der Ansprüche 13 und 14, wobei die Dicke mindestens einer aus der ersten und der zweiten Bondschicht (12, 22) weniger als 10 nm, ja sogar weniger als 6 nm beträgt.

## Claims

1. Method for the hydrophilic direct bonding of a first substrate (S1) onto a second substrate (S2), comprising:
• Providing a first substrate (S1) having a first main surface and a second substrate having a second main surface,
• bringing the first substrate (S1) and the second substrate (S2) into contact with one another, respectively via the first and second main surfaces thereof, so as to form a bonding interface (I) between two bonding surfaces,
• applying a heat treatment that is adapted to close said bonding interface (I),
said method being **characterised in that** it comprises, prior to the step of bringing the substrates into contact with one another, forming, on the first main surface and/or on the second main surface, a bonding layer (12, 13, 22, 23) made of an amorphous semiconductor material having doping elements and a thickness of less than or equal to 50 nm, a face of said bonding layer constituting one of the two bonding surfaces, an oxide layer being disposed less than 20 nm from the bonding interface.

2. Method according to the preceding claim, wherein the heat treatment is carried out at a temperature of substantially less than or equal to 900°C, preferably less than or equal to 600°C.

3. Method according to any one of the preceding claims, wherein the formation of the bonding layer (12, 22) made of an amorphous semiconductor material including doping elements comprises a step of depositing said amorphous semiconductor material on said main surface of the corresponding substrate (S1, S2), the doping elements being introduced into the bonding layer during or after the deposition of the amorphous semiconductor material by implantation.

4. Method according to any one of claims 1 to 2, wherein the formation of the bonding layer (12, 13, 22, 23) made of an amorphous semiconductor material including doping elements (13) comprises:
• a step of forming a so-called polycrystalline layer (14) containing a polycrystalline semiconductor material on said main surface of the corresponding substrate (S1, S2), then
• a step of amorphising at least part of the thickness of the polycrystalline layer (14), from an exposed surface thereof, so as to form said bonding layer (13), the latter preferably having a thickness substantially comprised between 1 and 20 nm, and preferably comprised between 2 and 5 nm,
the polycrystalline layer comprising the doping elements or these being introduced by implantation into the bonding layer after the amorphisation step.

5. Method according to any one of claims 1 to 2, wherein the formation of the bonding layer (12, 22) made of an amorphous semiconductor material including doping elements comprises:
• a step of forming a so-called polycrystalline layer (14) containing a doped, polycrystalline semiconductor material on said main surface of the corresponding substrate (S1), then
• a step of depositing the amorphous semiconductor material on the polycrystalline layer (14), the doping elements being introduced into the bonding layer during or after the deposition of the amorphous semiconductor material by implantation.

6. Method according to any one of the preceding claims, wherein the first substrate (S1) and the second substrate (S2) each comprise a layer made of a monocrystalline semiconductor material (10, 20), at least one of the first or second substrates including a layer made of a dielectric material (11, 21) disposed on the layer made of a monocrystalline semiconductor material, the first and/or the second main surface being formed by the free face of the layer made of a dielectric material.

7. Method according to any one of the preceding claims comprising, between the formation of the bonding layer (12, 22) and the bringing of the first substrate (S1) and the second substrate (S2) into contact with one another, a treatment to render both of the bonding surfaces (S1, S2) hydrophilic, followed by the application of water to both of said bonding surfaces to form a film of water thereon.

8. Method according to any one of the preceding claims further comprising, after bringing the first substrate (S1) and the second substrate (S2) into contact with one another, a step of thinning the first substrate (S1) so as to transfer a thin layer (101) of the first substrate onto the second substrate (S2).

9. Method according to any one of the claims further comprising, after bringing the first substrate and the second substrate into contact with one another, a step of crystallising at least part of the thickness of the bonding layer by heat treatment.

10. Method according to the preceding claim, wherein the content of doping elements in the bonding layer (12, 22) is configured, at least in terms of the nature and concentration of the doping elements, such that the crystallisation step generates an electrically conducting polycrystalline layer.

11. Method according to any one of the preceding two claims, wherein the crystallisation step is carried out by laser annealing.

12. Method according to any one of the preceding claims, wherein the bonding layer (12, 22) is placed under tensile or compressive stress.

13. Method according to any one of the preceding claims, wherein a first bonding layer (12) is produced on the first main surface and a second bonding layer (22) is produced on the second main surface.

14. Method according to claim 13, wherein the first and second bonding layers include doping elements that differ in terms of type (N or P) and/or nature and/or concentration.

15. Method according to any one of claims 13 and 14, wherein the thickness of at least one of the first or second bonding layers (12, 22) is less than 10 nm, or even less than 6 nm.
